Europäisches Patentamt

European Patent Office

Office européen des brevets

(11) Veröffentlichungsnummer: **0 357 822**

**A1**

(12) **EUROPÄISCHE PATENTANMELDUNG**

(21) Anmeldenummer: 88114647.6

(22) Anmeldetag: 08.09.88

(51) Int. Cl.5: **G01S 17/10 , H03K 5/153 , G04F 10/00**

(43) Veröffentlichungstag der Anmeldung:
**14.03.90 Patentblatt 90/11**

(84) Benannte Vertragsstaaten:
**AT BE CH DE ES FR GB GR IT LI LU NL SE**

(71) Anmelder: **Helmut K. Pinsch GmbH & Co.**
**Theodorstrasse 41h**
**D-2000 Hamburg 50(DE)**

(72) Erfinder: **Hatje, Günter H.**
**Theodorstrasse 41h**
**D-2000 Hamburg 50(DE)**

(74) Vertreter: **Patentanwälte Dipl.-Ing. J. Richter**
**Dipl.-Ing. F. Werdermann**
**Neuer Wall 10**
**D-2000 Hamburg 36(DE)**

(54) Verfahren zur Messung der Zeitdifferenz zwischen Impulsen und Einrichtung hierzu.

(57) Die Erfindung betrifft ein Verfahren zur Messung der Zeitdifferenz zwischen Impulsen mit endlicher Steigung und im wesentlichen symmetrischer Ausbildung, wobei die Amplitude eines Impulses veränderlich ist und der dem veränderlichen Impuls zugeordnete Meßzeitpunkt so ermittelt wird, daß das Überschreiten und/oder Unterschreiten eines Referenzwertes festgestellt und mit Hilfe dieses Zeitpunktes die Zeitdifferenz berechnet wird. Dabei wird ein Bereich ausgewählt, in dem die Steigung der Vorderflanke der der Hinterflanke des veränderlichen Impulses möglichst weitgehend entspricht. Der veränderliche Impuls wird über ein Verzögerungsglied (28) geleitet, dessen Ausgangssignal mit dem veränderlichen Impuls in unverzögertem Zustand verglichen wird. Das Vergleichsergebnis wird als maßgebender Zeitpunkt für die Messung der Zeitdifferenz verwendet.

FIG. 2

## Verfahren zur Messung der Zeitdifferenz zwischen Impulsen und Einrichtung hierzu

Die Erfindung betrifft ein Verfahren zur Messung der Zeitdifferenz zwischen Impulsen gemäß dem Oberbegriff von Anspruch 1 sowie eine Entfernungsmeßeinrichtung gemäß dem Oberbegriff von Anspruch 8.

Es ist bekannt, den zeitlichen Abstand zwischen zwei Impulsen zu messen, auch wenn die Impulse nicht als Rechteckimpulse ausgebildet sind. Dazu wird ein erster Zeitpunkt dadurch festgelegt, daß festgestellt wird, wann das Signal des ersten Impulses einen vorgegebenen Schwellenwert überschreitet. Ferner wird ein zweiter Zeitpunkt dadurch festgelegt, daß festgestellt wird, wann das Signal des zweiten Impulses einen weiteren vorgegebenen Schwellenwert berschreitet. Aus der Zeitdifferenz zwischen den beiden Zeitpunkten ergibt sich der zeitliche Abstand zwischen den Impulsen.

Diese Art der Bestimmung der Zeitdifferenz ist dann möglich, wenn die Impulse sowohl die gleiche Amplitude aufweisen als auch in ihrer Signalform einander entsprechen. In diesem Fall ist die Festlegung der Schwellenwerte relativ unkritisch.

Wenn jedoch eine der vorbezeichneten Bedingungen nicht erfüllt ist, führt das bekannte Verfahren zu Meßfehlern. Man hat daher versucht, die Schwellenwerte entsprechend anzupassen, indem beispielsweise für das Signal mit kleinerer Amplitude ein entsprechend proportional kleinerer Schwellenwert verwendet wird. Eine Anpassung der Schwellenwerte kann jedoch nicht vorgenommen werden, wenn die Amplitude eines der Impulse im Betrieb schwankt. Zwar könnte prinzipiell aus dem Anfangsverlauf eines Impulses die zu erwartende Amplitude bestimmt werden, vorausgesetzt, daß die Signalform gleichbleibend ist und lediglich die Amplitude schwankt. Aus der zu erwartenden Amplitude könnte dann der Schwellenwert ermittelt werden. Dieses Verfahren würde jedoch die Zuhilfenahme eines Rechners erfordern und wäre zudem immer noch mit einer vergleichsweise großen Ungenauigkeit behaftet. Die erwähnten Schwierigkeiten treten insbesondere bei Entfernungsmeßeinrichtungen auf. Bei derartigen Entfernungsmeßeinrichtungen wird ein Lichtstrahl auf ein Objekt geworfen. Ein Teil des von dem Objekt reflektierten Lichts wird von einem Detektor erfaßt. Nach Verstärkung des Ausgangssignals des Detektors ergibt sich ein gegenüber dem Sendesignal phasenverschobenes Signal, das beispielsweise einer Gaußfunktion entsprechen kann. Der Abstand zwischen dem Sendeimpuls und dem Empfangsimpuls ist aufgrund der Laufzeit des Lichts der zu messenden Entfernung proportional und kann mit einem der zuvor erläuterten Verfahren bestimmt werden. Der Reflexionsbeiwert $R_M$ des Objektes, dessen Entfernung zu bestimmen ist, kann jedoch beispielsweise im Bereich von 0,01 bis 0,5 liegen, so daß die Amplitude des Empfangsimpulses stark schwanken kann.

Ferner ist bekannt, die Verstärkung eines Verstärkers so zu regeln, daß das Ausgangssignal im wesent lichen konstant bleibt. Der Einsatz eines derart geregelten Verstärkers für den Verstärker, der an den Detektor angeschlossen wird, würde zu einer im wesentlichen gleichbleibenden Amplitude führen. Das zuvor erläuterte Meßverfahren würde jedoch immer noch einen vergleichsweise großen Meßfehler ergeben.

Bekannt ist auch ein Verfahren zur amplitudenunabhängigen Bestimmung eines relevanten Zeitpunkts eines impulsförmigen Signals, bei dem ein Teil eines Meßsignals über einen Abschwächer und ein weiterer Teil des Signals über ein Verzögerungsglied geleitet wird. Die Ausgangssignale des Abschwächers und des Verzögerungsgliedes werden miteinander verglichen. Mit diesem Verfahren soll ein relevanter Zeitpunkt des Signals amplitudenunabhängig bestimmt werden (US-PS 37 63 436).

Es hat sich jedoch gezeigt, daß die amplitudenunabhängige Bestimmung des relevanten Zeitpunktes gemäß diesem bekannten Verfahren nur bei Signalen mit vergleichsweise konstanter Steigung zuverlässig möglich ist. Bei Signalen, die zwar symmetrisch sind, jedoch keinen monoton und konstant steigenden Flankenverlauf aufweisen, führt daher dieses Verfahren zu Meßfehlern. Zudem ist die Messung nur in einem eingeschränkten Dynamikbereich möglich, zumal das Signal zur Messung noch abgeschwächt werden muß, so daß die Gefahr besteht, daß es von Rauschen überlagert ist.

Diese Probleme treten noch verstärkt bei einem anderen bekannten Meßverfahren auf, das als "Konstant-Bruchteil"-Verfahren bekannt ist und ähnlich wie das voranstehend beschriebene Verfahren arbeitet (DE-OS 29 12 653).

Demgegenüber ist es Aufgabe der Erfindung, ein Verfahren gemäß dem Oberbegriff von Anspruch 1 zu schaffen, daß die amplitudenunabhängige Bestimmung eines relevanten Zeitpunkts eines impulsförmigen Signals mit verbesserter Genauigkeit in einem vergrößerten Dynamikbereich erlaubt und bei welchem unabhängig von der Amplitude des veränderlichen Impulses eine sehr exakte Messung mit einfachen Mitteln möglich ist.

Diese Aufgabe wird erfindungsgemäß durch Anspruch 1 gelöst.

Der wesentliche Vorteil der Erfindung gegenüber dem Stand der Technik besteht darin, daß stets das Amplitudenmaximum des veränderlichen Signals ermittelt wird. Dieses Amplitudenmaximum hebt sich stets am besten von dem Grundrauschen ab.

Das erfindungsgemäße Verfahren läßt sich auch anwenden, wenn die Flankensteigung des veränderlichen Signals sich stark ändert, so lange die Symmetrie des Signals gewahrt ist und setzt somit im Gegensatz zu dem Stand der Technik keine Flanken mit im wesentlichen konstanter Steigung voraus.

Dabei kann vorteilhafterweise zur Dynamiksteigerung das Amplitudenmaximum des unverzögerten veränderlichen Signals bestimmt werden.

Bei dem bekannten Verfahren gemäß der US-PS 37 63 436 erfolgt die Abschwächung mit dem dortigen Attenuator 12 nur in vergleichsweise geringem Maße. Bereits bei einer geringsten Abschwächung ist aber die Symmetrie der Signale nicht mehr gewahrt, so daß es ohne Zuhilfenahme aufwendiger rechnerischer Methoden nicht möglich ist, das Amplitudenmaximum des ursprünglichen Signales zu bestimmen. Darüberhinaus ist keine Möglichkeit gegeben, dem dortigen Zeitpunkt t₀ als relevanten Zeitpunkt des veränderlichen Signals zu bestimmen, ohne daß der dortige Attenuator verwendet würde.

Vorteilhafterweise und überraschend läßt sich durch die erfindungsgemäßen Maßnahmen nicht nur die Genauigkeit bei der Bestimmung des tatsächlichen Amplitudenmaximus erhöhen, sondern auch der Dynamikbereich verbessern. Dadurch, daß beide Comparatoreingänge nämlich mit Signalen beaufschlagt werden, deren Maximum die gleiche Amplitude aufweist, wird stets der volle Dynamikbereich des Comparators ausgenutzt.

Das erfindungsgemäße Verfahren zeichnet sich auch dadurch aus, daß zunächst ein Impuls mit vorbestimmter Steigung verwendet wird. Bei im wesentlichen symmetrischer Ausbildung des Impulses ist die konstante Steigung der Vorderflanke gleich derjenigen der Hinterflanke. Besonders vorteilhaft ist es, daß diese Entsprechung auch bei veränderlicher Amplitude eines der Impulse aufrechterhalten bleibt. In diesem Fall ist die Steigung zwar vermindert, die Symmetrie bleibt jedoch gewahrt.

Erfindungsgemäß ist es vorgesehen, den Impuls mit veränderlicher Amplitude zu verzögern und mit dem unverzögerten veränderlichen Impuls zu vergleichen. Durch diese einfache Maßnahme läßt sich exakt ein amplitudenunabhängiger Zeitpunkt bestimmen, wenn die Symmetrie der Flanken gewahrt bleibt.

Die Größe der Verzögerung des Impulses mit veränderlicher Amplitude ist so zu wählen, daß sie in jedem Fall geringer als die Impulsbreite des Impulses ist. Gute Meßergebnisse lassen sich erzielen, wenn die Verzögerung etwa zu der Häfte der Impulsbreite gewählt wird. Die die Zeitdauer der Verzögerung bestimmenden Glieder müssen sehr konstant sein, da etwaige Schwankungen unmittelbar das Meßergebnis verfälschen würden.

Der tatsächliche Abstand zwischen den Impulsen läßt sich dadurch bestimmen, daß der Zeitpunkt des Impulses mit konstanter Amplitude beispielsweise mit Hilfe der an sich bekannten Schwellenwertmessung bestimmt wird und der Zeitpunkt des Impulses mit veränderlicher Amplitude aus dem Vergleichsergebnis zwischen dem verzögerten und dem verzögerten veränderlichen Impuls ermittelt wird.

Der Zeitpunkt, zu welchem der Pegel des verzögerten veränderlichen Impulses größer als derjenige des unverzögerten veränderlichen Impulses wird, ist unabhängig von der Amplitude des veränderlichen Impulses und dient als Zeitmeßreferenz. Der Spitzenwert des veränderlichen Impulses in unverzögerter Form läßt sich aufgrund der symmetrischen Ausbildung dieses Impulses dadurch bestimmen, daß die Hälfte der Verzögerung von dem ermittelten Referenzzeitpunkt subtrahiert wird.

In Anwendungsfällen, in welchen beide Impulse eine veränderliche Amplitude aufweisen, ist es erforderlich, für jeden der Impulse ein eigenes Verzögerungsglied bereitzustellen. Besonders günstig ist es dann, die Zeitdauer der Verzögerung für beide Impulse gleich zu wählen. In diesem Fall ist die Zeitdifferenz zwischen den Impulsen exakt der Zeitdifferenz zwischen den jeweils gemessenen Referenzzeitmeßwerten gleich.

Besonders vorteilhaft ist es, wenn der Empfänger eine gleiche oder eine niedrigere Bandbreite als der Sender aufweist. Dadurch werden zusätzlich Störungen durch Fremdsignale weitestgehend ausgeschlossen.

Bei der Anwendung in Verbindung mit Entfernungsmeßeinrichtungen ist es besonders vorteilhaft, daß die erfindungsgemäßen Maßnahmen auch in einem Zusatzmodul vereinigt werden können. Dieses kann bei vorhandenen Entfernungsmessern eingesetzt werden.

Vorteilhafte und zweckmäßige Weiterbildungen der Erfindung sind in den Unteransprüchen gekennzeichnet.

Ein Ausführungsbeispiel wird nachstehend anhand der Zeichnung erläutert. Es zeigen:

**Fig. 1** ein Zeitdiagramm von erfindungsgemäß ausgebildeten Impulsen;

**Fig. 2** eine schematische Darstellung der Schaltung einer erfindungsgemäßen Entfernungsmeßeinrichtung; und

**Fig. 3** die Signalverläufe an verschiedenen Punkten der Schaltung gemäß Fig. 2.

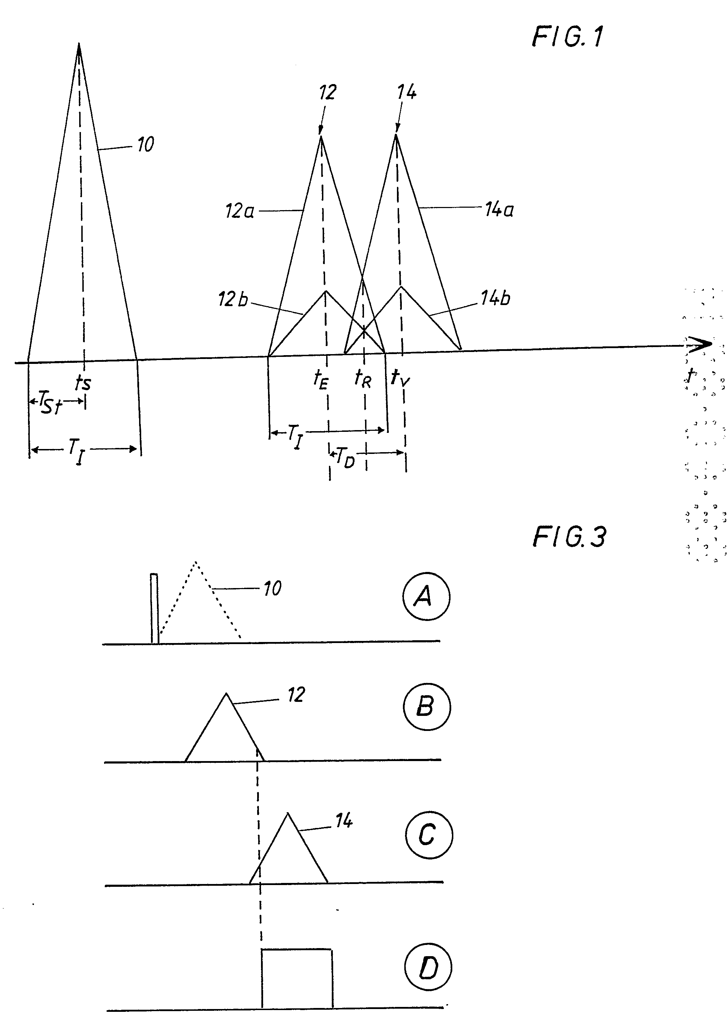

Nachfolgend wird das erfindungsgemäße Verfahren anhand der Anwendung bei einer Entfernungsmeßeinrichtung im einzelnen beschrieben In Fig.1 ist ein Sendeimpuls 10 dargestellt, der eine stets konstante Amplitude aufweist. Der Zeitpunkt, zu welchem der Sendeimpuls auftritt, wird durch manuelle Betätigung eines Auslöseknopfes in der Entfernungsmeßeinrichtung festgelegt. Der Sendeimpuls weist stets eine gleichbleibende Amplitude auf. Seine Signalform ist im wesentlichen dreieckförmig, d.h., die Steigung der Vorderflanke entspricht der Steigung der Hinterflanke des Sendeimpulses 10.

Das von der Entfernungsmeßeinrichtung ausgesendete Licht wird an einem Objekt reflektiert, dessen Entfernung zu der Entfernungsmeßeinrichtung zu messen ist, und trifft dann wiederum auf die Entfernungsmeßeinrichtung. In einem Detektor wird das Licht empfangen. Das Ausgangssignal des Detektors wird verstärkt und liegt dann als der in Fig.1 abgebildete Empfangsimpuls 12 vor. Die Signalform des ausgesendeten Lichts entspricht im wesentlichen derjenigen des empfangenen Lichts, wobei jedoch die Amplitude in der Regel unterschiedlich ist. Ferner schwankt die Amplitude des Empfangsimpulses, so daß der Empfangsimpuls eine große Amplitude aufweisen kann, wie es bei 12a dargestellt ist, oder eine kleine Amplitude, wie es bei 12b dargestellt ist. Die Größe der Amplitude ist abhängig von dem Reflexionsgrad des zu messenden Objektes sowie von der zu messenden Entfernung.

Der Empfangsimpuls 12 weist jedoch unabhängig von seiner Amplitude stets die gleiche Breite auf. Ferner ist der Zeitpunkt, zu welchem der Spitzenwert des Empfangsimpulses 12 vorliegt, unabhängig von der Amplitude des Empfangsimpulses, stets exakt in der Impulsmitte, da eine symmetrische Signalform vorliegt.

Die der Entfernung proportionale, zu messende Zeitdifferenz ist diejenige zwischen den Spitzenwerten der Impulse. Der Spitzenwert des Sendeimpulses 10 tritt zum Zeitpunkt $t_s$ und der Spitzenwert des Empfangsimpulses 12 zum Zeitpunkt $t_E$ auf. Der Empfangsimpuls 12 wird um die Dauer $T_D$ verzögert. In der verzögerten Form ist er in Fig.1 als verzögerter Empfangsimpuls 14 dargestellt, wobei der Empfangsimpuls bei großer Eingangsamplitude als verzögerter Empfangsimpuls 14a und bei kleiner Empfangsamplitude als verzögerter Empfangsimpuls 14b vorliegt

Abgesehen von der Verzögerung entspricht der Empfangsimpuls 14, insbesondere in seiner Signalform, vollständig dem unverzögerten Empfangsimpuls 12. Seinen Spitzenwert erreicht der verzögerte Empfangsimpuls 14 zum Zeitpunkt $t_V$. Der Zeitpunkt $t_V$ ist gegenüber dem Zeitpunkt $t_E$ um die Zeitdauer $T_D$ verzögert.

Da die Verzögerungs-Zeitdauer $T_D$ kleiner als die gesamte Breite $T_I$ des Empfangsimpulses 12 bzw. des verzögerten Empfangsimpulses 14 ist, ergibt sich ein Überlappungsbereich zwischen dem Empfangsimpuls 12 und dem verzögerten Empfangsimpuls 14. In diesem Überlappungsbereich steigt das Signal des verzögerten Empfangsimpulses 14 an, während das Signal des unverzögerten Empfangsimpulses 12 abfällt. Zu einem Referenz-Zeitpunkt $t_R$ ist der Pegel des unverzögerten Empfangsimpulses 12 gleich dem Pegel des verzögerten Empfangsimpulses 14. Der Referenz-Zeitpunkt $t_R$ wird als Referenz-Zeitpunkt für die Messung verwendet. Da die negative Steigung des unverzögerten Empfangsimpulses 12 aufgrund der symmetrischen Ausbildung des Empfangsimpulses exakt gleich der positiven Steigung des verzögerten Empfangsimpulses 14 ist, ist dieser Referenz-Zeitpunkt $t_R$ unabhängig von der Amplitude des Empfangsimpulses.

Der Referenz-Zeitpunkt $t_R$ kann mit einfachen schaltungstechnischen Mitteln bestimmt werden, wobei lediglich geprüft werden muß, wann der Pegel des verzögerten Empfangsimpulses 14 denjenigen des unverzögerten Empfangsimpulses 12 übersteigt.

Aufgrund der symmetrischen Ausbildung der Signale ist der Referenz-Zeitpunkt $t_R$ exakt um die Hälfte der Verzögerungs-Zeitdauer $T_D$ verzögert. Damit gilt:

$$t_E - t_S = t_R - T_D/2 - t_S.$$

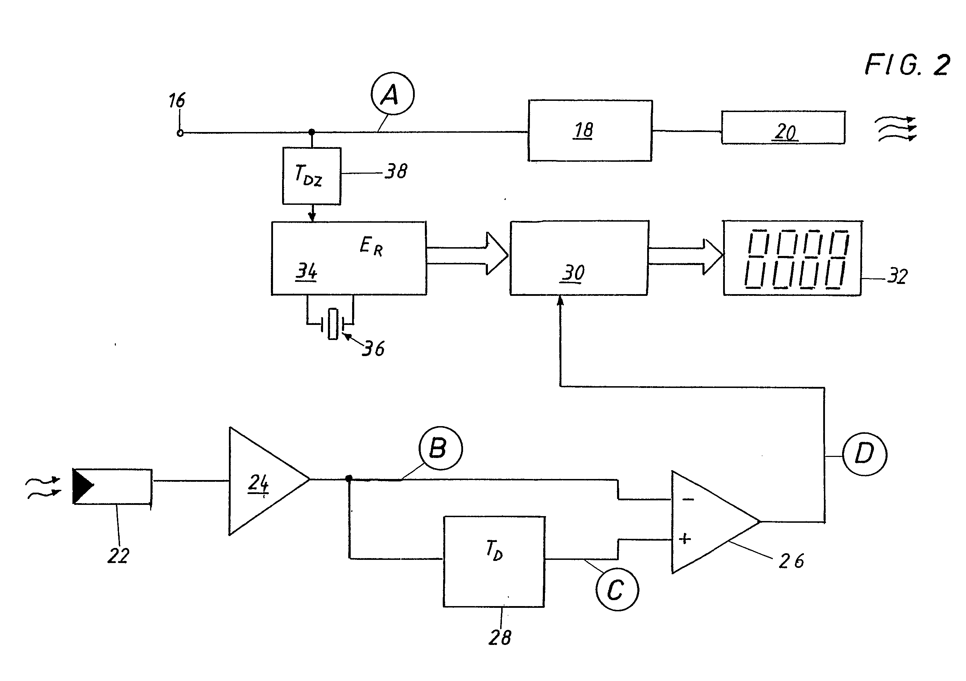

Die schaltungstechnische Realisierung einer Entfernungsmeßeinrichtung unter Verwendung des erfindungsgemäßen Verfahrens ist in Fig.2 dargestellt. Ein Startsignal wird an dem Anschlußpunkt 16 in die Entfernungsmeßeinrichtung eingegeben. Beispielsweise kann dies durch einen manuellen Betätigungsknopf erfolgen, der in dem Prinzipschaltbild gemäß Fig.2 nicht dargestellt ist. Das Startsignal triggert einen Impulsformer 18, der den Sendeimpuls entsprechend der in Fig.1 dargestellten Signalform ausbildet und eine Lichtquelle 20 mit dem entsprechenden Ansteuersignal beaufschlagt. Die Lichtquelle 20, die beispielsweise als Photodiode oder als Laser ausgebildet sein kann, sendet Licht zu dem Objekt aus, dessen Entfernung festgestellt werden soll. Ein Teil des Lichts wird an dem Objekt reflektiert und gelangt zurück zu der Entfer nungsmeßeinrichtung. Dort wird es von einem Detektor 22 erfaßt. Durch die Reflexion wird die Signalform des Lichtes praktisch nicht beeinflußt, so daß ein Empfangsimpuls entsteht, der im wesentlichen dem Empfangsimpuls 12 gemäß Fig 1 entspricht. Dieser Empfangsimpuls wird in einem Verstärker 24 und dadurch auf eine für die Signalverarbeitung geeignete Größe gebracht.

Das Ausgangssignal des Verstärkers wird dem invertierenden Eingangsanschluß eines Komparators 26 zugeführt. Ferner wird das Ausgangssignal des Verstärkers 24 einem Verzögerungsglied 28 zugeführt, welches das Signal um $T_D$ verzögert, ohne die Signalform oder die Amplitude zu ändern. Das Ausgangssignal des Verzögerungsgliedes wird dem nichtinvertierenden Eingangsanschluß des Komparators 26 zugeführt. Der Komparator 26 vermag somit festzustellen, zu welchem Zeitpunkt der Pegel des verzögerten Empfangsimpulses 14 größer und zu welchem Zeitpunkt er kleiner als der Pegel des unverzögerten Empfangsimpulses 12 ist.

Der Komparator 26 gibt ein Signal mit dem logischen Pegel "Null" ab, solange der unverzögerte Empfangsimpuls 12 größer als der verzögerte Empfangsimpuls 14 ist. Sobald der Pegel des verzögerten Empfangsimpulses größer als derjenige des unverzögerten Empfangsimpulses wird, schaltet der Komparator um, und es liegt der logische Pegel "Eins" an seinem Ausgang an. Das Umschalten des Ausgangssignals des Komparators 26 findet somit zum Referenz-Zeitpunkt $t_R$ statt.

Die Vorderflanke des Ausgangssignals des Komparators 26 triggert einen Übernahmeeingang eines Zwischenspeichers oder Latch 30. Latch 30 dient dabei zur Speicherung der gemessenen Zeitdifferenz und wirkt auf eine Anzeige 32, mit welcher die gemessene Zeitdifferenz numerisch anzeigbar ist.

Die reine Zeitmessung erfolgt mit Hilfe eines Zählers 34. Der Zähler 34 weist einen Rücksetzeingang $E_R$ auf. Er ist als Vorwärtszähler ausgebildet und wird von einer konstanten Taktquelle 36 mit einem geeigneten Takt-Eingangssignal versorgt.

Ferner ist der Anschlußpunkt 16 über ein Zusatz-Verzögerungsglied 38 mit dem Rücksetzeingangsanschluß $E_R$ des Zählers 34 verbunden.

Die Schaltung arbeitet bei der Messung folgendermaßen: Das an dem Anschlußpunkt 16 anliegende Startsignal wird verzögert auf den Rücksetz-Eingangsanschluß $E_R$ des Zählers 34 gelegt. Der Zähler 34 beginnt dann gesteuert von der Taktquelle 36 vorwärtszuzählen. Der aktuelle Zählerstand wird jeweils dem Latch 30 zugeleitet, aber noch nicht übernommen. Zum Zeitpunkt $t_R$ übernimmt das Latch 30 den gerade anstehenden Zählerstand des Zählers 34 und zeigt ihn auf der Anzeige 32 an. Damit entspricht der Zählerstand, der von dem Latch 30 übernommen wurde, der Zeitdauer bis zum Erreichen des Referenz-Zeitpunktes $t_R$.

Mit dem Zusatz-Verzögerungsglied 38 wird der Tatsache Rechnung getragen, daß der Zeitpunkt $t_R$ gegenüber dem Zeitpunkt $t_E$ um $T_D/2$ verzögert ist. Darüber hinaus verzögert das Zusatz-Verzögerungsglied 38 das am Anschlußpunkt 16 anliegende Signal um die Zeitdauer, die der Impulsformer 18 und die Lichtquelle 20 benötigt, um den Spitzenwert des Sendeimpulses zum Zeitpunkt $t_S$ zu erreichen. Diese Zeitperiode wird mit $T_{St}$ bezeichnet. Sie ist im wesentlichen gleich $T_I/2$, so daß die Verzögerung $T_{DZ}$ nach folgender Gleichung zu bestimmen ist:

$$T_{DZ} = T_D/2 + T_{St} = T_D/2 + T_I/2$$

Mit der Anordnung des Zusatzverzögerungsgliedes ergibt sich auf der Anzeige 32 ein Meßwert, der der Laufzeit des Lichtstrahls von der Lichtquelle 20 zu dem Detektor 22 unmittelbar proportional ist.

Selbstverständlich ist es auch möglich, das Zusatz-Verzögerungsglied 38 wegzulassen und zwischen Latch 30 und Anzeige 32 einen Rechner zwischenzuschalten, der eine Umrechnung der gemessenen Zeitperioden vornimmt und die zu messende Entfernung, beispielsweise in Metern, anzeigt.

Eine Nachrüstung einer bestehenden Entfernungsmeßeinrichtung kann leicht dadurch erfolgen, daß die Leitung zwischen dem Verstärker 24 und dem Latch 30, die normalerweise über einen Schmitt-Trigger-Schaltkreis geleitet wird, aufgetrennt wird, der Schmitt-Trigger-Schaltkreis entfernt wird und anstelle dessen das Verzögerungsglied 28 sowie der Komparator 26 in der erfindungsgemäßen Weise eingeschleift wird.

Weitere Abwandlungen sind möglich. So kann beispielsweise eine aus einem zusätzlichen Verzögerungsglied und einem zusätzlichen Komparator bestehende Schaltung anstelle des Zusatz-Verzögerungsgliedes 38 eingesetzt werden. Die Zeitdauer dieses Verzögerungsgliedes kann exakt gleich der Verzögerungs-Zeitdauer des Verzögerungsgliedes 28 gehalten werden, indem beispielsweise für beide Verzögerungsglieder die gleiche Zeitreferenz verwendet wird. In diesem Fall ergibt sich die Entfernung unmittelbar aus der Zeitdauer zwischen dem Zeitpunkt $t_R$ und der Vorderflanke des Eingangssignals an dem Rücksetz-Eingangsanschluß $E_R$ des Zählers 34.

In Fig. 3 ist der Signalverlauf an Punkten A bis D in dem Schaltbild gemäß Fig.2 in zueinander zeitrichtiger Beziehung dargestellt.

Wie ersichtlich ist, erfordert es das erfindungsgemäße Verfahren, die Zeitdauer $T_D$ geringer als die Zeitdauer $T_I$ zu wählen.

Während in Fig. 1 der Deutlichkeit halber der Sendeimpuls 10 so dargestellt ist, daß er mit dem unverzögerten Empfangsimpuls 12 nicht überlappt, wird in den meisten Anwendungsfällen, d.h. bei zu messenden Entfernungen im Bereich von wenigen Kilometern, eine Überlappung zwischen Sendeimpuls 10 und Empfangsimpuls 12 auftreten. Wie auch aus Fig.3 ersichtlich ist, ist eine derartige Überlappung unkritisch.

## Ansprüche

1. Verfahren zur Messung der Zeitdifferenz zwischen Impulsen mit endlicher Steigung und wesentlichen symmetrischer Ausbildung, wobei die Amplitude eines der Impulse von Messung zu Messung veränderlich ist und der dem veränderlichen Impuls zugeordnete Meßzeitpunkt so ermittelt wird, daß das Überschreiten und/oder Unterschreiten eines Referenzwertes festgestellt wird und mit Hilfe dieses Zeitpunktes die Zeitdifferenz berechnet wird,
dadurch gekennzeichnet,
daß ein Bereich ausgewählt wird, in dem die Steigung der Vorderflanke der der Hinterflanke des veränderlichen Impulses möglichst weitgehend entspricht, daß der veränderliche Impuls über ein Verzögerungsglied geleitet wird, daß das Ausgangssignal des Verzögerungsgliedes mit dem veränderlichen Impuls in unverzögertem Zustand verglichen wird und daß das Vergleichsergebnis als maßgebender Zeitpunkt für die Messung der Zeitdifferenz verwendet wird.

2. Verfahren nach Anspruch 1, dadurch gekennzeichnet, daß mindestens für den in seiner Größe veränderlichen Impuls ein symmetrischer Dreiecksimpuls verwendet wird.

3. Verfahren nach einem der Ansprüche 1 oder 2, dadurch gekennzeichnet, daß der veränderliche Impuls nach einem konstanten Impuls auftritt und eine Impulsform aufweist, die im wesentlichen derjenigen des konstanten Impulses entspricht.

4. Verfahren nach einem der vorhergehenden Ansprüche, dadurch gekennzeichnet, daß ein erster Impuls, insbesondere der konstante Impuls gemäß Anspruch 3, eine Quelle elektromagnetischer oder optischer Strahlung triggert und daß der veränderliche Impuls durch den Empfang eines Teils der elektr-magnetischen oder optischen Strahlung erzeugt wird.

5. Verfahren nach einem der vorhergehenden Ansprüche, dadurch gekennzeichnet, daß der erste Zeitpunkt der zu messenden Zeitdifferenz durch eine Flanke eines Startsignales gebildet wird.

6. Verfahren nach Anspruch 5, dadurch gekennzeichnet, daß die Flanke des Startsignales zugleich die Quelle elektromagnetischer Strahlung und eine Zeitmeßeinrichtung triggert, die das Verstreichen der Zeit bis zu dem maßgebenden Zeitpunkt mißt und anzeigt.

7 Verfahren nach einem der vorgehenden Ansprüche, dadurch gekennzeichnet, daß der in seiner Größe veränderliche Impuls einem Eingangsanschluß eines Komparators zugeleitet wird, daß der veränderliche Impuls ferner nach Durchlaufen des Verzögerungsgliedes dem anderen Eingangsanschluß eines Komparators zugeleitet wird und daß die Vorderflanke des Ausgangssignals des Komparators für die Bestimmung des maßgebenden Zeitpunktes herangezogen wird.

8. Entfernungsmeßeinrichtung zur Bestimmung der Entfernung von einem Strahlung reflektierenden Objekt, mit einer Quelle optischer Strahlung, insbesondere einem Laser, die Licht gebündelt aussendet, mit einem Detektor, der für die Frequenz des von der Quelle optischer Strahlung ausgesendeten Lichtes empfindlich ist und einen Teil der an dem Objekt reflektierten Strahlung zu erfassen vermag, wobei aus der Laufzeit des Impulses von der Quelle optischer Strahlung zum Detektor die Entfernung des Objektes bestimmbar ist, dadurch gekennzeichnet, daß ein Verzögerungsglied (28) für das Ausgangssignal des Detektors (22) vorgesehen ist, daß das Ausgangssignal des Detektors (22) einem Eingangsanschluß eines Komparators (26) und das Ausgangssignal des Verzögerungsgliedes (28) dem anderen Eingangsanschluß des Komparators (26) zugeführt wird und daß das Ausgangssignal des Komparators (26) für die Entfernungsmessung verwendet wird.

9. Entfernungsmeßeinrichtung nach Anspruch 8, dadurch gekennzeichnet, daß die Verzögerung des Verzögerungsgliedes (28) etwa die Hälfte der Sendeimpulsbreite ($T_I$) beträgt.

10. Entfernungsmeßeinrichtung nach einem der Ansprüche 8 oder 9, dadurch gekennzeichnet, daß das Ausgangssignal des Detektors (22) einem Verstärker (24) zugeführt wird, an dessen Ausgang der in seiner Größe veränderliche Impuls abgegriffen und dem Verzögerungsglied (28) zugeführt wird.

11. Entfernungsmeßeinrichtung nach einem der Ansprüche 8 bis 10, dadurch gekennzeichnet, daß die Bandbreite der Empfängereinrichtung (Detektor 22, Verstärker 24) gleich oder geringer als die Bandbreite des Senders ist.

12. Entfernungsmeßeinrichtung nach Anspruch 11, dadurch gekennzeichnet, daß die Bandbreite der Empfängereinrichtung im wesentlichen der maximal möglichen Steigung des Empfangsimpulses entspricht.

13. Entfernungsmeßeinrichtung nach einem der Ansprüche 8 bis 12 zur amplitudenunabhängigen Bestimmung eines relevanten Zeitpunktes eines symmetrischen, impulsförmigen zweiten Signals als ein Teil einer Einrichtung zur Messung der Zeitdifferenz zwischen einem ersten und zweiten Signal ist, dadurch gekennzeichnet, daß das zweite Signal über ein Verzögerungsglied verzögert und das verzögerte Signal einem Eingangsanschluß eines Komparators zugeführt wird, daß die Verzögerungszeit des Verzögerungsgliedes (28) kleiner als die Breite des zweiten Signals ist, daß das zweite Signal im unverzögerten Zustand dem anderen Eingangsanschluß des Komparators (26) zugeführt und ein Signalwechsel am Ausgang des Komparators (26) ermittelt wird, zu welchem die Amplitude des verzögerten zweiten Signals die Amplitude des unverzögerten zweiten Signals übersteigt, und daß die Hälfte der Verzögerungszeit des Verzögerungsgliedes (28) von der zwischen Signaländerung am Ausgang des Komparators (26) und Amplitudenmaximum der ersten Signals liegenden Zeit substrahiert und so das Amplitudenmaximum des hinsichtlich der Amplitude veränderlichen zweiten Signals bestimmt wird.

*FIG. 1*

*FIG. 3*

FIG. 2

EP 0 357 822 A1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | INSTRUMENTS AND EXPERIMENTAL TECHNIQUES, Band 25, Nr. 4, Teil 2, Juli/August 1982, Seiten 915-917, Plenum Publishing Corp., New York, US; A.A. ALEKSANDROV et al.: "Pulse shaper for time clamping to the rising edge of pulses in semiconductor detectors" * Seiten 915,916; Figuren 1,2 * --- | 1-3,7 | G 01 S 17/10 H 03 K 5/153 G 04 F 10/00 |
| Y | Idem --- | 4-6,8-13 | |
| Y | EP-A-0 022 747 (KERN) * Zusammenfassung; Seite 7, Zeile 10 - Seite 8, Zeile 1; Figur 2 * --- | 4-6,8-13 | |
| X | EP-A-0 257 292 (ZELLWEGER USTER) * Spalte 3, Zeile 10 - Spalte 5, Zeile 18; Figuren 1-5 * ----- | 1-13 | |
| | | | **RECHERCHIERTE SACHGEBIETE (Int. Cl.4)** |
| | | | G 01 S H 03 K G 04 F |

Der vorliegende Recherchenbericht wurde für alle Patentansprüche erstellt

| Recherchenort | Abschlußdatum der Recherche | Prüfer |
|---|---|---|
| DEN HAAG | 26-04-1989 | VAN WEEL E.J.G. |